# EUROPÄISCHE PATENTANMELDUNG

(11) **EP 4 195 896 A1**
(43) Veröffentlichungstag der Anmeldung: **14.06.2023**
(21) Anmeldenummer: 22212501.5
(22) Anmeldetag: 09.12.2022
(51) Int. Cl.: H05K 7/20

(54) **SELBSTENTWÄRMBARE BAUGRUPPE SOWIE ENTITÄT, INSBESONDERE FÜR DEN KRAFTFAHRZEUGBEREICH**

(30) Priorität: 09.12.2021 DE 102021132382
(71) Anmelder: Yazaki Systems Technologies GmbH, 93059 Regensburg (DE)
(72) Erfinder: RODERER, Götz, 93105 Tegernheim (DE); EINERT, Martin, 93077 Bad Abbach (DE)
(74) Vertreter: Patentanwaltskanzlei WILHELM & BECK

(57) **Zusammenfassung**

Die Erfindung betrifft eine selbstentwärmbare Baugruppe (1), bevorzugt eine selbstentwärmbare elektrische oder leistungselektrische Baugruppe (1), insbesondere für den Kraftfahrzeugbereich, mit einer sich erwärmbaren eigentlichen Baugruppe (10) mit wenigstens einem Baugruppenelement (11) und einer die eigentliche Baugruppe (10) entwärmbare Wärmeleiteinrichtung (20), wobei die Wärmeleiteinrichtung (20) als eine flexibel formbare Wärmeleiteinrichtung (20) ausgebildet ist.

## Beschreibung

Die Erfindung betrifft eine selbstentwärmbare Baugruppe, bevorzugt eine selbstentwärmbare elektrische oder leistungselektrische Baugruppe, insbesondere für den Kraftfahrzeugbereich. Ferner betrifft die Erfindung eine Entität, bevorzugt eine elektrische oder leistungselektrische Entität, insbesondere für den Kraftfahrzeugbereich.

Ein Einsatz elektrischer oder leistungselektrischer Baugruppenelemente, z. B. von Schalteinheiten wie Transistoren jeder Bauart, z. B. MosFETs (Metalloxid-Halbleiter-Feldeffekttransistoren), oder auch jede Form von (leistungs-)elektrischen Verbindungselementen erzeugt über einen ohmschen Widerstand Abwärme. Speziell bei Schaltelementen wird auf einem engen Raum u. U. sehr viel Wärme freigesetzt. Deshalb ist oft eine Kühlung oder ein Anschluss an ein Kühlsystem einer damit ausgerüsteten elektrischen oder leistungselektrischen Entität notwendig. Zur Wärmeabfuhr werden heute unterschiedliche Kühlungen eingesetzt, die je nach Konzeption und Ausführung mehr oder etwas weniger kostenintensiv sind. Im unteren Kostensegment bedient man sich Kühlrippen, welche eine freigesetzte Wärme von einer Wärmequelle (Hotspot) abtransportieren und großflächig, u. U. mit Unterstützung eines Ventilators, an eine Umgebung abgeben.

Eine betreffende Umgebung ist dabei ein wichtiger Begriff. Auf Ebene eines Geräts betrachtet wird eine von einer Wärmequelle einer Baugruppe des Geräts erzeugte Wärme abgeführt und an eine ,Umgebung' direkt im Gerät abgegeben. Dadurch erwärmt sich diese innere lokale Baugruppen-Umgebung im Gerät, was wiederum zu einer höheren Temperatur der gesamten wärmeerzeugenden Baugruppe führt, wobei eine Temperatur im Gerät kleiner als die der Wärmequelle ist. Dies ist natürlich nur dann anwendbar, wenn die Wärmequelle und somit die lokale Baugruppen-Umgebung im Gerät nicht zu heiß werden. Diese lokale Baugruppen-Umgebung bzw. das Innere des Geräts wiederum führt die Wärme über ein Gehäuse des Geräts an eine übergeordnete lokale Umgebung oder die äußere Umgebung ab, wobei das Gehäuse zum Teil über Kühlrippen, Kühlfinnen oder ein anderes Kühlsystem, wie z. B. eine Wasser- oder Ölkühlung, verfügen kann.

Dieser Prozess ist physikalisch durchaus effizient, jedoch sind die Kühlelemente (Kühlrippen oder Kühlfinnen) dennoch kostenintensiv, da sie für einen guten bis sehr guten Wärmetransport meist aus einem Metall bzw. einer Metalllegierung gefertigt werden müssen.

Weiterhin muss eine Anbindung eines Kühlelements an eine Wärmequelle, z. B. das elektrische oder leistungselektrische Baugruppenelement nach Möglichkeit gut sein, wozu häufig Kontaktmaterialien wie Wärmeleitpasten eingesetzt sind, was die Montagekosten erhöht. Aufgrund der Kühlelemente kann eine Platzierung der Baugruppenelemente auf einer Platine ferner nicht immer deren optimale Position und/oder Anbindung auf der Platine ergeben, wobei diese für eine Konstruktion und auch eine Montage auf der Platine, häufig zunächst auf/an dem Kühlelement platziert werden und erst dieses dann montiert wird.

Um eine Wärmeenergie an die äußere Umgebung abzugeben, sind also multiple Wärme-übergänge und -transportmechanismen notwendig: von der Wärmequelle zum Kontaktmaterial, vom Kontaktmaterial zum Kühlelement, vom Kühlelement an die Luft bzw. ein Medium in der lokalen Geräte-Umgebung (Innenraum), von der Luft bzw. dem Medium in der lokalen Geräte-Umgebung (Innenraum) zum Gehäuse, vom Gehäuse an die Luft bzw. ein Medium in ggf. wenigstens einer weiteren, übergeordneten lokalen Umgebung und schließlich die äußere Umgebung. Alternativ kann die Wärme auch von der Wärmequelle zur Luft bzw. einem Medium in einer übergeordneten lokalen oder auch die äußere Umgebung mit Hilfe einer direkte Wärmebrücke transportiert werden. Diese sind aus Metall und erfordern eine hohe Präzision bei der Fertigung, da Komponenten und Gehäuse passgenau miteinander verbunden werden müssen, um einen Wärmetransport zu ermöglichen.

Aus dem Stand der Technik ergibt sich das Problem eines Sandwichaufbaus mit einer Vielzahl von Schichten, die einer effizienten Kühlung einer Baugruppe, die selbst eine Wärmequelle aufweist oder von einer solchen gewärmt wird (ebenfalls als Wärmequelle bezeichnet) im Wege stehen. - Es ist eine Aufgabe der Erfindung eine kostengünstige Kühlung für eine sich selbst erwärmende und/oder eine fremd erwärmbare Baugruppe anzugeben. Unter einer Baugruppe ist dabei eine Mehrzahl von Bauteilen und/oder Komponenten, eine Vorrichtung, eine Einrichtung, eine Unterbaugruppe, ein Modul etc. verstanden.

Die Aufgabe der Erfindung ist mittels einer selbstentwärmbaren Baugruppe, bevorzugt einer selbstentwärmbaren elektrischen oder leistungselektrischen Baugruppe, insbesondere für den Kraftfahrzeugbereich; und mittels einer Entität, bevorzugt einer elektrischen oder leistungselektrischen Entität, insbesondere für den Kraftfahrzeugbereich, gemäß den unabhängigen Ansprüchen gelöst. - Vorteilhafte Weiterbildungen, zusätzliche Merkmale und/oder Vorteile der Erfindung ergeben sich aus den abhängigen Ansprüchen und der folgenden Beschreibung.

Die erfindungsgemäße selbstentwärmbare Baugruppe umfasst eine sich erwärmbare eigentliche Baugruppe, bevorzugt eine eigentliche elektrische oder leistungselektrische Baugruppe, mit wenigstens einem Baugruppenelement, bevorzugt einem elektrischen oder leistungselektrischen Baugruppenelement, und eine die eigentliche Baugruppe entwärmbare Wärmeleiteinrichtung, wobei die Wärmeleiteinrichtung als eine flexibel formbare Wärmeleiteinrichtung ausgebildet ist. - Solch eine selbstentwärmbare Baugruppe kann z. B. diskrete und/oder integrierte (auch als ,elektronisch' bezeichnet) elektrische oder leistungselektrische Baugruppenelemente, elektromechanische, mechanische, fluidische und/oder optische Baugruppenelemente aufweisen. Die selbstentwärmbare Baugruppe kann dabei z. B. als eine Vorrichtung; eine Einrichtung, z. B. eine Platine für ein Kraftfahrzeug, ein (leistungs-)elektrisches Verbindungselement; eine Unterbaugruppe; ein Modul etc. ausgebildet sein.

Die sich erwärmbare eigentliche Baugruppe kann als eine selbst erwärmbare und sich selbst erwärmende, und/oder die sich erwärmbare eigentliche Baugruppe kann als eine fremd erwärmbare und sich fremd erwärmende eigentliche Baugruppe ausgebildet sein. Die Wärmeleiteinrichtung kann als eine passive Wärmebrücke oder ein aktiver Kühlkörper ausgebildet sein. Im ersten Fall leitet die Wärmeleiteinrichtung die Wärme aus der eigentlichen Baugruppe ab, ohne dass weitere Maßnahmen zur Kühlung getroffen sind. Im zweiten Fall ist die Wärmeleiteinrichtung abseits der eigentlichen Baugruppe aktiv gekühlt.

Die eigentliche Baugruppe kann an wenigstens einer Seite wenigstens eine Wärmeleiteinrichtung aufweisen. Ferner kann die eigentliche Baugruppe an zwei, bevorzugt einander gegenüberliegenden, Seiten wenigstens eine Wärmeleiteinrichtung aufweisen. - Die Wärmeleiteinrichtung kann auf einem freien Ende des Baugruppenelements ansitzen. Ferner kann die Wärmeleiteinrichtung wenigstens eine Seite abseits eines freien Endes des Baugruppenelements wenigstens teilweise abdecken. Des Weiteren kann die Wärmeleiteinrichtung mit ihrem freien Ende mit einem Gehäuse einer Entität in mechanischen und somit wärmeleitenden Kontakt bringbar sein.

In Ausführungsformen kann die Wärmeleiteinrichtung auf das wenigstens eine Baugruppenelement aufgesteckt sein. Hierbei kann lediglich eine Steckverbindung zwischen der Wärmeleiteinrichtung und dem Baugruppenelement existieren. Zwischen der eigentlichen Baugruppe oder dem wenigstens einen Baugruppenelement und der Wärmeleiteinrichtung kann eine Wärmeleitpaste eingerichtet sein. Die Wärmeleiteinrichtung und die eigentliche Baugruppe können stofflich einstückig miteinander verbunden sein. Hierbei können die Wärmeleiteinrichtung und die eigentliche Baugruppe miteinander verklebt sein, was z. B. durch einen Wärmeleitkleber erfolgen kann.

Die flexibel formbare Wärmeleiteinrichtung kann elastisch und/oder plastisch verformbar ausgebildet sein. Die Wärmeleiteinrichtung kann einen Schaum, bevorzugt ein Festschaum oder einem Weichschaum, aufweisen. Ein Schaum ist durch gasförmige Bläschen gekennzeichnet, die durch feste, d. h. nicht-flüssige, Wände in einem Fest- oder Weichkörper getrennt sind. Hierbei kann die Wärmeleiteinrichtung z. B. als eine Schaumplatte aus einem verfestigten Schaum ausgebildet sein. Des Weiteren kann die Wärmeleiteinrichtung einen Kunststoffschaum, einen Schaumstoff oder einen Metallschaum aufweisen. Darüber hinaus kann die Wärmeleiteinrichtung als ein Montageschaum, ein Ortschaum oder ein Formschaum ausgebildet sein. Weiterhin kann die Wärmeleiteinrichtung als ein Wärmeleitschaum und/oder ein Partikelschaum ausgebildet sein.

Daneben kann die Wärmeleiteinrichtung einen Schwamm, ein Schaumglas oder ein Aerogel aufweisen. Hierbei ist natürlich Wert auf eine gute Wärmeleitfähigkeit der Wärmeleiteinrichtung gelegt, wobei z. B. bei einem Aerogel ggf. noch Entwicklungsarbeit zu leisten ist, wie mit einem solchen eine gute Wärmeleitung erzielbar ist. - Durch seine Eigenschaft als flexibel formbare Wärmeleiteinrichtung kann ein kostengünstiges Kühlelement (passive Wärmebrücke oder aktiver Kühlkörper), z. B. aus einem Schaum, leicht auf einer Wärmequelle platziert (gesteckt) und ggf. verklebt werden, wobei dank einer geringen Masse der Wärmeleiteinrichtung keine Verschraubung notwendig ist. Eine Flexibilität bzw. Nachgiebigkeit der Wärmeleiteinrichtung erzeugt eine gute Oberflächenanpassung an die eigentliche Baugruppe. Eine Nacharbeit der Wärmeleiteinrichtung ist problemlos möglich.

In Ausführungsformen kann die flexibel formbare Wärmeleiteinrichtung wenigstens ein Material aufweisen, das einen Wärmeleitkoeffizient besitzt, der deutlich größer als der eines typischen Schaums ist. Ferner kann die Wärmeleiteinrichtung zur Verbesserung ihrer Wärmeleitfähigkeit Metallpartikel, Graphene und/oder Carbon Nanotubes aufweisen. Darüber hinaus kann die Wärmeleiteinrichtung als eine elektrisch isolierende und/oder komprimierbare Wärmeleiteinrichtung ausgebildet sein.

Ein Körper der Wärmeleiteinrichtung kann im Wesentlichen oder hauptsächlich vollständig mit einem Feststoff gefüllt ausgebildet sein. Die Wärmeleiteinrichtung kann wenigstens teilweise als ein gerader oder schiefer Zylinder oder Hohlzylinder mit regelmäßiger oder allgemeiner Grundfläche ausgebildet sein. Die Wärmeleiteinrichtung kann wenigstens teilweise als ein gerades oder schiefes Parallelepiped oder hohles Parallelepiped ausgebildet sein. Die Wärmeleiteinrichtung kann wenigstens teilweise als ein Polyeder oder ein hohler Polyeder ausgebildet sein.

Da die Wärmeleiteinrichtung flexibel formbar ist kann die Wärmeleiteinrichtung natürlich beliebige Formen annehmen. Diese flexible Formbarkeit ist dadurch gegeben, dass eine Konsistenz der Wärmeleiteinrichtung weich, elastisch und/oder hartschaumartig-weich ist. Hierdurch ist es möglich, dass sich die Wärmeleiteinrichtung durch ihre Komprimierbarkeit von selbst an eine Umgebung anpasst. Ferner kann eine hartschaumartig-weiche Wärmeleiteinrichtung einfach bearbeitet werden (Thermosäge, Raspel, Feile, Stechen und Brennen von Ausnehmungen etc.).

Insbesondere ist es möglich, die Wärmeleiteinrichtung an einen Innenraum anzupassen und dabei groß oder nahezu so groß wie möglich auszubilden, um eine gute Wärmeleitung durch die Wärmeleiteinrichtung zu erhalten, falls dies bei den gegebenen Örtlichkeiten sinnvoll ist. Dies kann insbesondere auch durch einen Montageschaum, Ortschaum oder Formschaum erzielt werden, der beim Applizieren in einen Innenraum den Innenraum raumgreifend ausfüllt.

In Ausführungsformen kann die Wärmeleiteinrichtung auf/an der eigentlichen Baugruppe eingerichtet sein. Ferner kann in Ausführungsformen die eigentliche Baugruppe wenigstens teilweise oder im Wesentlichen vollständig in die Wärmeleiteinrichtung eingebettet sein. - Insbesondere können sich durch die Erfindung deutlich geringere Materialkosten sowie deutlich geringere Herstellkosten (kein Fräßen oder Gießen) ergeben. Ferner besteht keine Gefahr von Beschädigungen anderer Komponenten, da die erfindungsgemäße Wärmeleiteinrichtung leicht und weich ist und keine scharfen Kanten aufweisen kann.

Die erfindungsgemäße Entität weist eine erfindungsgemäße selbstentwärmbare Baugruppe auf. Die Entität kann dabei z. B. als eine Einrichtung; ein Modul, z. B. eine HV-Verteilerbox für ein Elektrofahrzeug; ein Apparat; ein Gerät, z. B. ein Steuergerät für ein Kraftfahrzeug; eine Anlage; ein System etc. ausgebildet sein. - Die Wärmeleiteinrichtung der selbstentwärmbaren Baugruppe kann mit einem Gehäuse der Entität in einem mechanischen und somit wärmeleitenden Kontakt stehen. Ferner kann die Wärmeleiteinrichtung der selbstentwärmbaren Baugruppe mit einem aktiven Kühler in einem fluidmechanischen und/oder mechanischen und somit wärmeübertragenden Kontakt stehen. Solch ein aktiver Kühler ist z. B. ein Ventilator, ein Wärmetauscher etc. Des Weiteren kann die Wärmeleiteinrichtung der selbstentwärmbaren Baugruppe mit einem Gehäuse einer zweiten Entität in einen mechanischen und somit wärmeleitenden Kontakt bringbar sein.

Die wenigstens eine Wärmeleiteinrichtung kann als eine passive Wärmebrücke (an ein Umgebungsmedium, meist Luft; eine Wandung etc.) der Entität oder ein aktiver Kühlkörper (zusätzlich mit einem Wärmstauscher, z. B. einem Ventilator, einer Kühlschlage etc.) der Entität ausgebildet sein. Im ersten Fall leitet die Wärmeleiteinrichtung die Wärme aus der eigentlichen Baugruppe in die Entität ab und ggf. an einen Randbereich, z. B ein Gehäuse, der Entität, ohne dass weitere Maßnahmen zur Kühlung der Entität getroffen sind. Im zweiten Fall ist die Wärmeleiteinrichtung abseits der eigentlichen Baugruppe aktiv gekühlt.

Die Erfindung ist im Folgenden anhand von Ausführungsbeispielen unter Bezugnahme auf die beigefügte schematische und nicht maßstabsgetreue Zeichnung näher erläutert. Abschnitte, Elemente, Bauteile, Einheiten, Komponenten und/oder Schemata, welche eine identische, univoke oder analoge Ausbildung und/ oder Funktion besitzen, sind in der Figurenbeschreibung (s. u.), der Bezugszeichenliste, den Patentansprüchen und in den Figuren (Fig.) der Zeichnung mit denselben Bezugszeichen gekennzeichnet. Eine mögliche, in der Erfindungsbeschreibung (s. o.) nicht erläuterte, in der Zeichnung nicht dargestellte und/oder nicht abschließende Alternative, eine statische und/ oder kinematische Umkehrung, eine Kombination etc. zu den Ausführungsbeispielen der Erfindung bzw. einer Komponente, einem Schema, einer Einheit, einem Bauteil, einem Element oder einem Abschnitt davon, kann ferner der Bezugszeichenliste und/oder der Figurenbeschreibung entnommen werden.

Bei der Erfindung kann ein Merkmal (Abschnitt, Element, Bauteil, Einheit, Komponente, Funktion, Größe etc.) positiv, d. h. vorhanden, oder negativ, d. h. abwesend, ausgestaltet sein. In dieser Spezifikation (Beschreibung (Erfindungsbeschreibung (s. o.), Figurenbeschreibung (s. u.)), Bezugszeichenliste, Patentansprüche, Zeichnung) ist ein negatives Merkmal als Merkmal nicht explizit erläutert, wenn nicht gemäß der Erfindung Wert daraufgelegt ist, dass es abwesend ist. D. h. die tatsächlich gemachte und nicht eine durch den Stand der Technik konstruierte Erfindung darin besteht, dieses Merkmal wegzulassen.

Ein Merkmal dieser Spezifikation kann nicht nur in einer angegebenen Art und/oder Weise, sondern auch in einer anderen Art und/oder Weise angewendet sein (Isolierung, Zusammenfassung, Ersetzung, Hinzufügung, Alleinstellung, Weglassung etc.). Insbesondere ist es möglich, anhand eines Bezugszeichens und einem diesem zugeordneten Merkmal bzw. vice versa, in der Beschreibung, der Bezugszeichenliste, den Patentansprüchen und/oder der Zeichnung, ein Merkmal in den Patentansprüchen und/oder der Beschreibung zu ersetzen, hinzuzufügen oder wegzulassen. Darüber hinaus kann dadurch ein Merkmal in einem Patentanspruch ausgelegt und/oder näher spezifiziert werden.

Die Merkmale der Beschreibung sind (angesichts des (zunächst meist unbekannten) Stands der Technik) auch als optionale Merkmale interpretierbar; d. h. ein jedes Merkmal kann als ein fakultatives, arbiträres oder bevorzugtes, also als ein nicht verbindliches, Merkmal aufgefasst werden. So ist eine Herauslösung eines Merkmals, ggf. inkl. seiner Peripherie, aus einem Ausführungsbeispiel möglich, wobei dieses Merkmal dann auf einen verallgemeinerten Erfindungsgedanken übertragbar ist. Das Fehlen eines Merkmals (negatives Merkmal) in einem Ausführungsbeispiel zeigt, dass das Merkmal in Bezug auf die Erfindung optional ist. Ferner ist bei einem Artbegriff für ein Merkmal auch ein Gattungsbegriff für das Merkmal mitlesbar (ggf. weitere hierarchische Gliederung in Untergattung etc.), wodurch, z. B. unter Beachtung von Gleichwirkung und/oder Gleichwertigkeit, eine Verallgemeinerung des Merkmals möglich ist.

In den lediglich beispielhaften Figuren (Fig.) zeigen:
die Fig. 1 und 2 in allseitig weggebrochenen Perspektivansichten, eine Montage einer Wärmeleiteinrichtung an/auf einer erwärmbaren eigentlichen Baugruppe zur selbstentwärmbaren Baugruppe für eine Entität, insbesondere für den Kraftfahrzeugbereich,
die Fig. 3 bis 6 in jeweils einer weggebrochenen Schnittansicht eine Ausführungsform einer elektrischen oder leistungselektrischen Entität, wobei die Entität eine selbstentwärmbare Baugruppe aufweist, die eine sich erwärmbare eigentliche Baugruppe und eine die eigentliche Baugruppe entwärmbare passive Wärmeleiteinrichtung umfasst, und
die Fig. 7 und 8 in zu den Fig. 3 bis 6 analogen Darstellungen jeweils eine Ausführungsform der Wärmeleiteinrichtung, wobei die Wärmeleiteinrichtung abseits der eigentlichen Baugruppe zusätzlich aktiv gekühlt ist und somit als ein aktiver Kühlkörper wirkt.

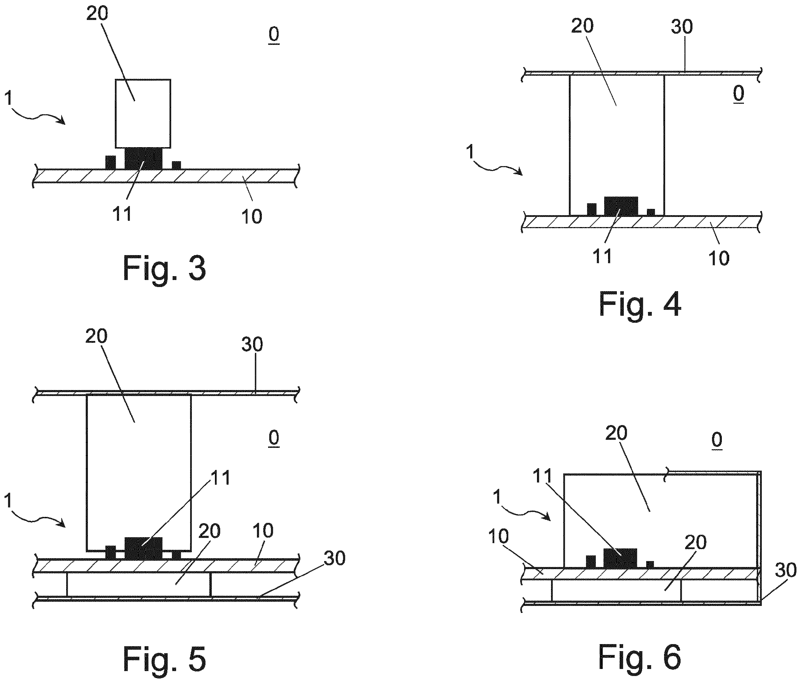

Die Erfindung ist im Folgenden anhand von Ausführungsbeispielen von sechs Ausführungsformen (Fig. 3 bis 8) einer Variante einer selbstentwärmbaren Baugruppe 1, bevorzugt einer selbstentwärmbaren elektrischen oder leistungselektrischen Baugruppe 1, für eine Entität 0, bevorzugt eine elektrische oder leistungselektrische Entität 0, insbesondere für den Kraftfahrzeugbereich näher erläutert. Obwohl die Erfindung detaillierter durch Ausführungsformen näher beschrieben und illustriert ist, so ist die Erfindung nicht durch die offenbarten Ausführungsformen eingeschränkt, sondern ist von grundlegenderer Natur. Andere Variationen können hieraus und/oder aus Obigem (Erfindungsbeschreibung) abgeleitet werden, ohne den Schutzumfang der Erfindung zu verlassen. Die Erfindung ist dabei allgemein im mechanischen, (leistungs-)elektrischen (auch elektrische Energietechnik und Analoga (sehr hohe bis maximale elektrische Ströme und Spannungen)), fluidischen und/oder optischen Bereich bei einer Entität 0 anwendbar (vgl. o.).

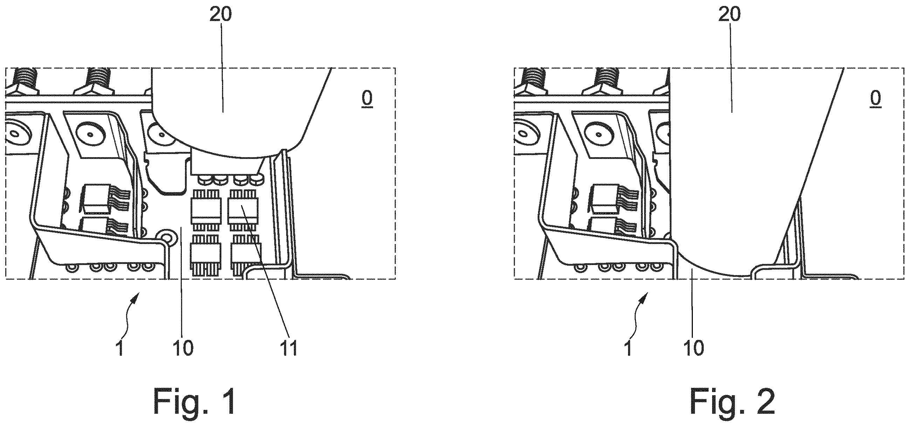

In der Zeichnung sind nur diejenigen räumlichen Abschnitte eines Gegenstands der Erfindung dargestellt, welche für ein Verständnis der Erfindung notwendig sind. - Die Zeichnung zeigt, einmal von der Fig. 1 abgesehen, in ihrer jeweiligen Fig. einen Ausschnitt einer erfindungsgemäßen Entität 0 mit einer erfindungsgemäßen selbstentwärmbaren Baugruppe 1.

Die selbstentwärmbare Baugruppe 1, vgl. die Zeichnung, umfasst eine sich in ihrem Betrieb aktiv selbst erwärmende, eigentliche Baugruppe 10 (selbst erwärmbare und/oder sich selbst erwärmende Baugruppe 10), mit einem Baugruppenelement 11, welches eine abzuführende Wärme erzeugt. Es ist natürlich möglich, dass die selbstentwärmbare Baugruppe 1 passiv erwärmbar ist und erwärmt wird, d. h. die eigentliche Baugruppe 10 der selbstentwärmbaren Baugruppe 1 umfasst ein passiv erwärmbares Baugruppenelement 11 (fremd erwärmbare und/oder sich fremd erwärmende Baugruppe 10).

Hierbei ist das Baugruppenelement 11 als ein sich selbst erwärmendes (primäre Wärmequelle) oder fremd erwärmtes (sekundäre Wärmequelle) und zu kühlendes Baugruppenelement 11 ausgebildet. Das Baugruppenelement 11 kann dabei ein-, mehr- oder vielteilig ausgebildet sein. So kann das Baugruppenelement 11 z. B. als ein Transistor 11, ein (leistungs-)elektrisches Verbindungselement 11 (Terminal 11), ein Hochspannungs- 11 und/oder Hochstrombauteil 11, eine Hochspannungs- und/oder Hochstrombaugruppe 11, eine Platine 11 etc. ausgebildet sein.

Ferner umfasst die selbstentwärmbare Baugruppe 1 neben ihrer eigentlichen Baugruppe 10 eine flexibel formbare Wärmeleiteinrichtung 20. Die Wärmeleiteinrichtung 20 kann dabei auf/an einer Seite der eigentlichen Baugruppe 10 der selbstentwärmbaren Baugruppe 1 vorgesehen sein. Ferner kann die eigentliche Baugruppe 10 in die Wärmeleiteinrichtung 20 eingebettet sein. Hierbei kann die eigentliche Baugruppe 10 teilweise in die Wärmeleiteinrichtung 20 hineinragen oder im Wesentlichen vollständig in der Wärmeleiteinrichtung 20 aufgenommen sein. Im letzten Fall kann natürlich noch eine Seite der eigentlichen Baugruppe 10 außen an/innen in der Wärmeleiteinrichtung 20 sichtbar sein.

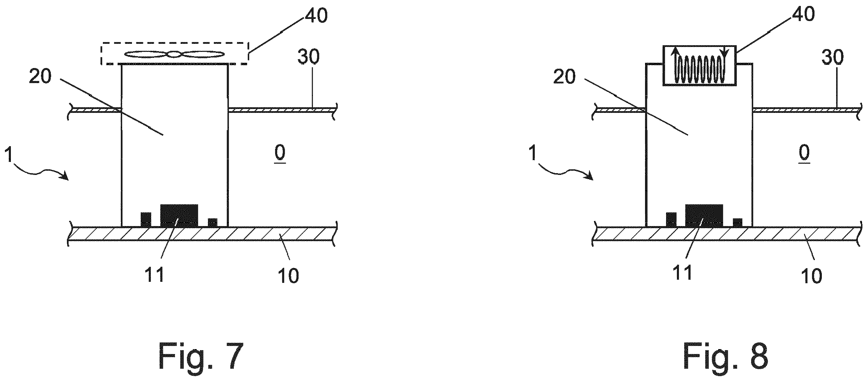

Die Wärmeleiteinrichtung 20 kann z. B. als eine passive Wärmebrücke (Fig. 1 bis 6) der selbstentwärmbaren Baugruppe 1 bzw. der Entität 0, oder als ein aktiver Kühlkörper (Fig. 7 und 8) der selbstentwärmbaren Baugruppe 1 bzw. der Entität 0 konzipiert sein. Die Wärmeleiteinrichtung 20 als passive Wärmebrücke 20 überträgt die Wärme aus dem Baugruppenelement 11 z. B. an ein Umgebungsmedium, meist Luft; eine Wandung eines Gehäuses 30 einer Entität (0) etc. Als ein aktiver Kühlkörper 20 weist die Wärmeleiteinrichtung 20 aktiven Kühler 40 z. B. einen Ventilator, einen Wärmetauscher etc. auf.

Die flexibel formbare Wärmeleiteinrichtung 20 kann z. B. elastisch und/oder plastisch verformbar ausgebildet sein. Hierbei kann die Wärmeleiteinrichtung 20 einen flexibel formbaren und insbesondere festen Schaum (vgl. oben) aufweisen. Hierbei weist die Wärmeleiteinrichtung 20 bzw. deren Schaum eine bevorzugt gute Wärmeleitung und somit einen entsprechenden Wärmeleitkoeffizient auf. Hierbei kann der Schaum zur Verbesserung seiner Wärmeleitfähigkeit wenigstens einen Zusatzstoff aufweisen. Insbesondere ist die Wärmeleiteinrichtung 20 bzw. deren Schaum elektrisch isolierend. Ferner kann die Wärmeleiteinrichtung 20 insbesondere als eine kompressible bzw. komprimierbare Wärmeleiteinrichtung 20 ausgebildet sein.

Die Fig. 1 und 2 zeigen eine sehr einfache Montage der Wärmeleiteinrichtung 20 an/auf der eigentlichen Baugruppe 10. Hierbei wird die Wärmeleiteinrichtung 20 wenigstens auf das mindestens eine Baugruppenelement 11 und somit die eigentliche Baugruppe 10 aufgesetzt bzw. aufgesteckt (Fig. 1 nach 2). Hierbei sitzt die Wärmeleiteinrichtung 20 wenigstens auf einem freien Ende des Baugruppenelements 11 auf. Ferner kann die Wärmeleiteinrichtung 20 wenigstens mit dem freien Ende des Baugruppenelements 11 verklebt sein (Wärmeleitkleber). Darüber hinaus kann zusätzlich oder alternativ wenigstens zwischen dem freien Ende des Baugruppenelements 11 und der Wärmeleiteinrichtung 20 eine Wärmeleitpaste eingerichtet sein. Hierbei weist die eigentliche Baugruppe 10 an lediglich einer Seite die Wärmeleiteinrichtung 20 auf. Die Fig. 3 zeigt eine dazu analoge Ausführungsform, jedoch mit einem deutlich kleinerem Baugruppenelement 11. Hier, wie auch eben, ist die Wärmeleiteinrichtung 20 als eine Wärmebrücke 20 zu einem Medium (meist Luft) eines Innenraums der Entität 0 ausgebildet.

In der Fig. 4 ist die Wärmeleiteinrichtung 20 derart ausgebildet bzw. derart weit auf das mindestens eine Baugruppenelement 11 geschoben, dass dieses im Wesentlichen vollständig in der Wärmeleiteinrichtung 20 aufgenommen ist. Eine Verklebung, also eine stofflich einstückige Verbindung, und/oder eine Wärmeleitpaste sind natürlich anwendbar. Hierbei kann die Verklebung und/oder die Wärmeleitpaste zwischen der Wärmeleiteinrichtung 20 und der eigentlichen Baugruppe 10 eingerichtet sein. Statt einer Verklebung und einer Wärmeleitpaste ist z. B. auch ein Wärmeleitkleber anwendbar, der sich hier auch für andere Verklebungen der Wärmeleiteinrichtung 20 eignet.

Für eine Montage der Baugruppe 10 in der Wärmeleiteinrichtung 20 kann die Wärmeleiteinrichtung 20 entsprechend ausgenommen sein. Es ist auch möglich, dass ein komprimierbares Material der Wärmeleiteinrichtung 20 eine elastische und/oder plastische Verformung der Wärmeleiteinrichtung 20 bei deren Montage auf dem Baugruppenelement 11 erlaubt, wobei sich die Wärmeleiteinrichtung 20 entsprechend elastisch und/oder plastisch verformt, sodass das Baugruppenelement 11 im Wesentlichen vollständig in der Wärmeleiteinrichtung 20 aufgenommen werden kann. Ferner ist es natürlich möglich, dass das Baugruppenelement 11 lediglich teilweise in der Wärmeleiteinrichtung 20 aufgenommen ist (Fig. 5).

Ferner zeigen die Fig. 4 und 5 die Wärmeleiteinrichtung 20 als eine Wärmebrücke zu einer dem Baugruppenelement 11 gegenüberliegenden Wandung eines Gehäuses 30 der Entität 0. D. h. die Wärme des Baugruppenelements 11 kann ohne Konvektion und lediglich durch Wärmeleitung durch die Wärmeleiteinrichtung 20 vom Baugruppenelement 11 (Wärmeübergang an die Wärmeleiteinrichtung 20) an die Wandung (Wärmeübergang von der Wärmeleiteinrichtung 20) des Gehäuses 30 transportiert werden. Das Gehäuse 30 kann die Wärme weiter nach außen, z. B. an eine übergeordnete lokale Umgebung in einer übergeordneten Entität oder auch die äußere Umgebung transportieren. Die Wärmeleiteinrichtung 20 kann dabei in der Entität 0 geklemmt zwischen der Wandung des Gehäuses 30 und dem Baugruppenelement 11 bzw. der eigentlichen Baugruppe 10 eingerichtet sein.

Des Weiteren zeigt die Fig. 5 einen Einsatz zweier Wärmeleiteinrichtungen 20 für wenigstens ein Baugruppenelement 11. Die erste Wärmeleiteinrichtung 20 ist dabei wie oben beschrieben eingerichtet. Eine zweite Wärmeleiteinrichtung 20 ist dabei gegenüberliegend zur ersten Wärmeleiteinrichtung 20 an einer zum Baugruppenelement 11 gegenüberliegenden Seite der eigentlichen Baugruppe 10 eingerichtet, die z. B. als eine Platine 10 mit dem wenigstens ein Baugruppenelement 11 ausgebildet sein kann. Hierbei ist wie zweite Wärmeleiteinrichtung 20 zwischen der dem Baugruppenelement 11 abseitigen Seite der eigentlichen Baugruppe 10 und wiederum einer Wandung des Gehäuses 30 der Entität 0 vorgesehen.

Die Fig. 6 zeigt eine Wärmeleiteinrichtung 20, die in einem Eckbereich der Entität 0 eingerichtet ist. Hierbei transportiert die Wärmeleiteinrichtung 20 Wärme aus dem Baugruppenelement 11 zu wenigstens zwei Wandungen eines Gehäuses 30 der Entität 0. Ferner zeigt die Fig. 6 analog zur Fig. 5 eine zweite Wärmeleiteinrichtung 20. Die jeweilige Wärmeleiteinrichtung 20 kann dabei wiederum mit einem einen Wärmeübergang verbessernden Anpressdruck, der z. B. von der Montage herrührt, an der jeweiligen Wandung des Gehäuses 30 ansitzen.

Die Fig. 7 und 8 zeigen die Wärmeleiteinrichtung 20 als einen Kühlkörper mit einem aktiven Kühler 40. Hierbei weist die jeweilige Wärmeleiteinrichtung 20 den aktiven Kühler 40 an einer zum Baugruppenelement 11 gegenüberliegenden Seite auf. Ferner zeigen die Fig. 7 und 8 jeweils eine Ausführungsform der Entität 1, bei welcher sich deren Wärmeleiteinrichtung 20 durch eine Wandung z. B. eines Gehäuses 30 der Entität 1 hindurcherstreckt. Hierdurch ist die Wärme aus dem Baugruppenelement 11 und einem Innenraum, in welchem sich das Baugruppenelement 11 befindet, heraus hinter die Wandung transportierbar. Die Funktionen des aktiven Kühlers 40 und des Hindurchragens der Wärmeleiteinrichtung 20 durch die Wandung können natürlich getrennt voneinander realisiert sein.

In der Fig. 7 ist der aktive Kühler 40 als ein Ventilator 40 ausgebildet, der einen darunter liegenden Längsendabschnitt der Wärmeleiteinrichtung 20 mit einem erzwungenen Konvektionsstrom des dort vorherrschenden gasförmigen Mediums, meist Luft, beaufschlagen kann. In der Fig. 8 ist der aktive Kühler 40 als ein Wärmetauscher 40 (Kühlschlange) ausgebildet, der teilweise in der Wärmeleiteinrichtung 20 eingerichtet ist. Es ist natürlich möglich, den Wärmetauscher 40 vollständig in der Wärmeleiteinrichtung 20 unterzubringen oder auch nur außen auf der Wärmeleiteinrichtung 20 vorzusehen.

Eine Form der Wärmeleiteinrichtung 20 ist prinzipiell beliebig bzw. kann einfach an die Gegebenheiten in und ggf. an der Entität 0 angepasst sein bzw. werden. Bevorzugt sind regelmäßige Formen wie z. B. die eines geraden oder schiefen Zylinders oder Hohlzylinders, die eines geraden oder schiefen Quaders oder Hohlquaders, die eines geraden oder schiefen Parallelepipeds oder hohlen Parallelepipeds etc. Eine Grundfläche des Zylinders oder Hohlzylinders kann dabei regelmäßig oder allgemein sein. Natürlich ist auch die Form eines Polyeders oder hohlen Polyeders etc. anwendbar.

In Ausführungsformen kann die bevorzugt als ein Schaumkörper 20 ausgebildete Wärmeleiteinrichtung 20 als eine passive Wärmebrücke (Fig. 1 bis 6), als ein aktiver Kühlkörper (Fig. 7 und 8) etc. zwischen dem Baugruppenelement 11 bzw. der eigentlichen Baugruppe 10 und einer beliebigen Umgebung eingesetzt sein. Solch eine Umgebung ist z. B. eine lokale innere Umgebung der Entität 0, eine Wandung in der Entität 0, eine Wandung eines Gehäuses 30 der Entität 0, eine Wandung eines Gehäuses einer übergeordneten Entität, eine Wandung einer übergeordneten Entität, eine übergeordnete lokale Umgebung, eine äußere Umgebung etc. Ferner kann solch eine Umgebung von einem aktiven Kühler 40, wie z. B. einem Ventilator, einem Wärmetauscher etc. begrenzt sein. Hierbei kann die Wärmeleiteinrichtung 20 den aktiven Kühler 40 aufweisen.

Durch eine Nachgiebigkeit der Wärmeleiteinrichtung 20 ist keine hohe Präzision bei deren Fertigung und/oder Montage notwendig. Einigermaßen korrekt dimensioniert ergibt eine Elastizität eines Materials der Wärmeleiteinrichtung 20 bei einem ausreichenden Übermaß von selbst einen Anpressdruck durch deren Montage. Hierdurch stellt sich ein verbesserter Wärmeübergang sowohl von einer Wärmequelle (Baugruppenelement 11) auf die Wärmeleiteinrichtung 20 als auch von der Wärmeleiteinrichtung 20 zur Umgebung ein. Zusätzliche Kühlrippen, Kühlfinnen o. ä. können eine Wärmeabgabe an ein Medium in einer lokalen Umgebung oder die Luft der äußeren Umgebung weiter verbessern. Grundsätzlich kann solch eine Wärmeleiteinrichtung 20 als passive Wärmebrücke (Konvektion) bzw. als aktiver Kühlkörper (erzwungene Konvention, Wind) zur äußeren Umgebung eingesetzt sein.

### Bezugszeichenliste

- 0: Entität, bevorzugt elektrische oder leistungselektrische Entität
- 1: selbstentwärmbare Baugruppe, bevorzugt selbstentwärmbare elektrische oder leistungselektrische Baugruppe
- 10: (selbst oder fremd erwärmbare) eigentliche Baugruppe mit wenigstens einem Baugruppenelement 11
- 11: Baugruppenelement, bevorzugt elektronisches oder leistungselektrisches Baugruppenelement 11; beliebiges Bauteil, das sich in einem Betrieb der Entität 0 selbst erwärmt oder von der Entität 0 oder einer anderen Entität fremd erwärmt wird
- 20: flexibel formbare Wärmeleiteinrichtung, bevorzugt passive Wärmebrücke oder aktiver Kühlkörper; z. B. Schaumkörper
- 30: Gehäuse der Entität 0
- 40: aktiver Kühler der Wärmeleiteinrichtung 20, z. B. Ventilator, Wärmetauscher etc.

## Patentansprüche

1. Selbstentwärmbare Baugruppe (1), bevorzugt selbstentwärmbare elektrische oder leistungselektrische Baugruppe (1), insbesondere für den Kraftfahrzeugbereich, mit
einer sich erwärmbaren eigentlichen Baugruppe (10) mit wenigstens einem Baugruppenelement (11) und einer die eigentliche Baugruppe (10) entwärmbare Wärmeleiteinrichtung (20), **dadurch gekennzeichnet, dass**
die Wärmeleiteinrichtung (20) als eine flexibel formbare Wärmeleiteinrichtung (20) ausgebildet ist.

2. Selbstentwärmbare Baugruppe (1) gemäß vorhergehendem Anspruch, **dadurch gekennzeichnet, dass** die sich erwärmbare eigentliche Baugruppe (10) als eine selbst erwärmbare und sich selbst erwärmende, und/oder die sich erwärmbare eigentliche Baugruppe (10) als eine fremd erwärmbare und sich fremd erwärmende eigentliche Baugruppe (10) ausgebildet ist.

3. Selbstentwärmbare Baugruppe (1) ausgebildet ist, Baugruppe gemäß einem der vorhergehenden Ansprüche, **dadurch gekennzeichnet, dass**:
• die Wärmeleiteinrichtung (20) als eine passive Wärmebrücke oder ein aktiver Kühlkörper ausgebildet ist,
• die eigentliche Baugruppe (10) an wenigstens einer Seite wenigstens eine Wärmeleiteinrichtung (20) aufweist, und/oder
• die eigentliche Baugruppe (10) an zwei, bevorzugt einander gegenüberliegenden, Seiten wenigstens eine Wärmeleiteinrichtung (20) aufweist.

4. Selbstentwärmbare Baugruppe (1) gemäß einem der vorhergehenden Ansprüche, **dadurch gekennzeichnet, dass**:
• die Wärmeleiteinrichtung (20) auf einem freien Ende des Baugruppenelements (11) ansitzt,
• die Wärmeleiteinrichtung (20) wenigstens eine Seite abseits eines freien Endes des Baugruppenelements (11) wenigstens teilweise abdeckt, und/oder
• die Wärmeleiteinrichtung (20) mit ihrem freien Ende mit einem Gehäuse (30) einer Entität (0) in mechanischen Kontakt bringbar ist.

5. Selbstentwärmbare Baugruppe (1) gemäß einem der vorhergehenden Ansprüche, **dadurch gekennzeichnet, dass**:
• die Wärmeleiteinrichtung (20) auf das wenigstens eine Baugruppenelement (11) aufgesteckt ist,
• zwischen der eigentlichen Baugruppe (10) oder dem wenigstens einen Baugruppenelement (11) und der Wärmeleiteinrichtung (20) eine Wärmeleitpaste eingerichtet ist, und/ oder
• die Wärmeleiteinrichtung (20) und die eigentliche Baugruppe (10) stofflich einstückig miteinander verbunden sind.

6. Selbstentwärmbare Baugruppe (1) ausgebildet ist, Baugruppe gemäß einem der vorhergehenden Ansprüche, **dadurch gekennzeichnet, dass** die flexibel formbare Wärmeleiteinrichtung (20):
• elastisch und/oder plastisch verformbar ausgebildet ist,
• einen Schaum, bevorzugt ein Festschaum oder einem Weichschaum, aufweist,
• einen Kunststoffschaum, einen Schaumstoff oder einen Metallschaum aufweist,
• als ein Montageschaum, ein Ortschaum oder ein Formschaum ausgebildet ist, und/oder
• als ein Wärmeleitschaum und/oder ein Partikelschaum ausgebildet ist.

7. Selbstentwärmbare Baugruppe (1) gemäß einem der vorhergehenden Ansprüche, **dadurch gekennzeichnet, dass** die flexibel formbare Wärmeleiteinrichtung (20):
• wenigstens ein Material aufweist, das einen Wärmeleitkoeffizient besitzt, der deutlich größer als der eines typischen Schaums ist,
• zur Verbesserung ihrer Wärmeleitfähigkeit Metallpartikel, Graphene und/oder Carbon Nanotubes aufweist, und/oder
• als eine elektrisch isolierende und/oder komprimierbare Wärmeleiteinrichtung (20) ausgebildet ist.

8. Selbstentwärmbare Baugruppe (1) gemäß einem der vorhergehenden Ansprüche, **dadurch gekennzeichnet, dass**:
• ein Körper der Wärmeleiteinrichtung (20) im Wesentlichen oder hauptsächlich vollständig mit einem Feststoff gefüllt ausgebildet ist,
• die Wärmeleiteinrichtung (20) wenigstens teilweise als ein gerader oder schiefer Zylinder oder Hohlzylinder mit regelmäßiger oder allgemeiner Grundfläche ausgebildet ist,
• die Wärmeleiteinrichtung (20) wenigstens teilweise als ein gerades oder schiefes Parallelepiped oder hohles Parallelepiped ausgebildet ist, und/oder
• die Wärmeleiteinrichtung (20) wenigstens teilweise als ein Polyeder oder ein hohler Polyeder ausgebildet ist.

9. Selbstentwärmbare Baugruppe gemäß einem der vorhergehenden Ansprüche, **dadurch gekennzeichnet, dass** die Wärmeleiteinrichtung (20) auf/an der eigentlichen Baugruppe (10) eingerichtet ist, und/oder
die eigentliche Baugruppe (10) wenigstens teilweise oder im Wesentlichen vollständig in die Wärmeleiteinrichtung (20) eingebettet ist.

10. Entität (0), bevorzugt elektrische oder leistungselektrische Entität (0), insbesondere für den Kraftfahrzeugbereich, **dadurch gekennzeichnet, dass** die Entität (0) eine selbstentwärmbare Baugruppe (1) gemäß einem der vorhergehenden Ansprüche aufweist.

11. Entität (0) gemäß vorhergehendem Anspruch, **dadurch gekennzeichnet, dass**:
• die Wärmeleiteinrichtung (20) der selbstentwärmbaren Baugruppe (1) mit einem Gehäuse (30) der Entität (0) in einem mechanischen Kontakt steht,
• die Wärmeleiteinrichtung (20) der selbstentwärmbaren Baugruppe (1) mit einem aktiven Kühler (40) in einem fluidmechanischen und/oder mechanischen Kontakt steht,
• die Wärmeleiteinrichtung (20) der selbstentwärmbaren Baugruppe (1) mit einem Gehäuse (30) einer zweiten Entität in einen mechanischen und somit wärmeleitenden Kontakt bringbar ist, und/oder
• die wenigstens eine Wärmeleiteinrichtung (20) als eine passive Wärmebrücke (20) der Entität (0) oder ein aktiver Kühlkörper (20) der Entität (0) ausgebildet ist.
